**Europäisches Patentamt**

(19) **European Patent Office**

**Office européen des brevets**

(11) Publication number: **0 070 499**
**B1**

(12) **EUROPEAN PATENT SPECIFICATION**

(45) Date of publication of patent specification: **30.12.86**

(21) Application number: **82106245.2**

(22) Date of filing: **13.07.82**

(51) Int. Cl.⁴: **H 01 L 21/00**

(54) **A method of producing a semiconductor device.**

(30) Priority: **15.07.81 JP 110466/81**
**17.07.81 JP 111863/81**

(43) Date of publication of application:
**26.01.83 Bulletin 83/04**

(45) Publication of the grant of the patent:
**30.12.86 Bulletin 86/52**

(84) Designated Contracting States:
**DE FR GB**

(56) References cited:
**EP-A-0 017 377**
**US-A-4 092 209**
**US-A-4 242 791**

(73) Proprietor: **FUJITSU LIMITED**
**1015, Kamikodanaka Nakahara-ku**
**Kawasaki-shi Kanagawa 211 (JP)**

(72) Inventor: **Goto, Hiroshi**
**Nanseiso, 3-4-4, Hiyoshi Kohoku-ku**
**Yokohama-shi Kanagawa. 223 (JP)**

(74) Representative: **Seeger, Wolfgang, Dipl.-Phys.**
**European Patent Attorney Bereiteranger 15**
**D-8000 München 90 (DE)**

Courier Press, Leamington Spa, England.

## Description

This invention relates to a method of producing bipolar walled-emitter transistors with improved insulation between the emitter and base electrodes.

In the bipolar type semiconductor integrated circuit device, as a method of improving integration density, it has been proposed to realize dielectric isolation between the active element or passive element formed on the semiconductor substrate or layer by a so-called dielectric isolation method.

Such dielectric isolation method utilizes an oxide material, such as silicon dioxide, as an isolation material, which is formed by oxidizing the semiconductor substrate or layer up to the specified depth, for example, by the selective or local oxidation method using a silicon nitride film as mask. For the formation of a bipolar type semiconductor integrated circuit device having the dielectric isolation structure using such oxide as an isolation material, for example, a bipolar transistor allows the isolation region, collector contact region forming window and base region forming window to be formed at a time by a composed photo mask. Therefore, such dielectric isolation method is very effective for improving integration density by forming small size transistors. Here, the base region is formed by introducing the acceptor impurity using the thick oxide film formed by such selective oxidation method as the mask.

However, even in such bipolar transistors formed by the dielectric isolation method, the emitter region forming window formed within said base region is not self-aligned for said base region. For this reason, a sufficiently large margin for alignment is required between said emitter region forming window and base region forming window. Therefore, if the photo mask is misaligned at the time of forming such emitter region forming window, not only the insulating film on the base region but also the field insulating film around the base region are removed by the etching, and when the specified impurity is introduced from the emitter region forming the window, the emitter and collector get short-circuited.

Short-circuits between emitter and collector naturally drastically deteriorate production yield and reliability of semiconductor devices.

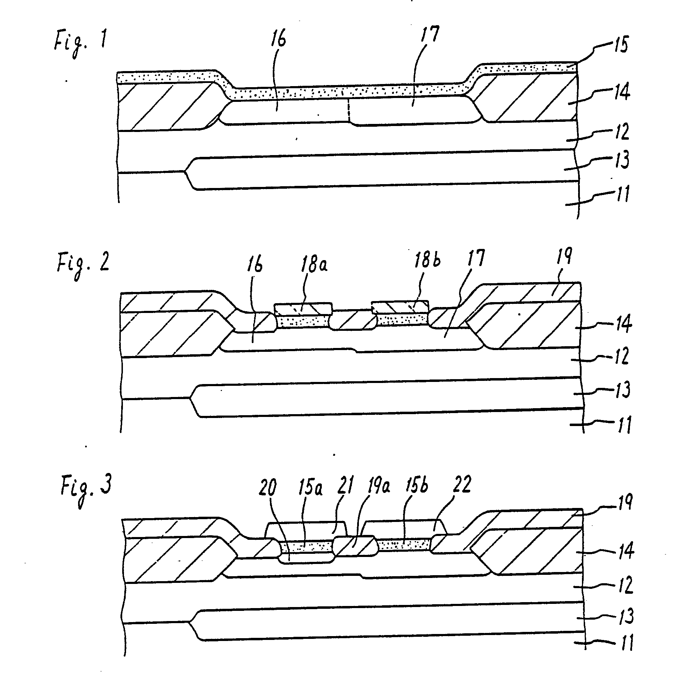

Thus, for example, a means indicated in Fig. 1 to Fig. 3 is proposed in order to eliminate the problem occurring at the time of such alignment of photo mask.

In regard to Fig. 1:

(1) In accordance with said existing method, the n type silicon epitaxial layer 12 formed by the epitaxial growth method is formed on the P type silicon (Si) semiconductor substrate 11. 13 is the $n^+$ type buried layer selectively formed at the surface of the P type silicon substrate 11 prior to formation of the P type epitaxial layer 12.

(2) The surface of said n type epitaxial layer 12 is selectively or locally oxidized using as mask the silicon nitride ($Si_3N_4$) layer (not shown) and the field insulating layer 14 consisting of the silicon dioxide ($SiO_2$) is formed.

(3) Said silicon nitride layer is removed.

(4) the polycrystalline silicon layer 15 is formed covering the field insulating layer and the exposed n type epitaxial layer 12.

(5) The P type base region 16 is formed by introducing the acceptor impurity through said polycrystalline silicon layer 15.

(6) Moreover, the $P^+$ type base contact region 17 is formed by depositing the photoresist layer (not shown) on said polycrystalline silicon layer 15 and by introducing, thereto the acceptor impurity in a high concentration with said photoresist used as the mask.

In regard to Fig. 2:

(7) The silicon nitride film pattern 18a corresponding to the emitter region forming a window and emitter electrode contact window and the silicon nitride film pattern 18b corresponding to the base electrode contact window are formed on said polycrystalline silicon layer 15.

(8) Said polycrystalline silicon layer 15 is selectively oxidized with said silicon nitride film patterns 18a and 18b used as the mask, thereby the unmasked polycrystalline silicon layer and a part of the surface of the P type silicon layer 12 located thereunder are converted to the silicon dioxide film 19.

(9) Said silicon nitride film patterns 18a and 18b are removed. As a result, the polycrystalline silicon layers 15a and 15b under said silicon nitride film patterns are exposed.

(10) the $n^+$ type emitter region 20 is formed by introducing the donor impurity in high concentration into the base region through the polycrystalline silicon layer 15a by the ion implantation method with the photo resist (not shown) used as mask or solid to solid diffusion method.

(11) The emitter electrode 21 and base electrode 22 are formed by depositing the metal material such as aluminium (Al) on said polycrystalline silicon layers 15a, 15b. In such a producing method, the window opening by the photo etching is not carried out when said emitter region is formed.

Therefore, in case a part of the emitter region is placed in contact with the field insulating layer, the short-circuit between the emitter and collector as explained previously does not occur.

Resultingly such producing method realized a so-called walled emitter structure where a part of the emitter region is placed in contact with the field insulating layer. This walled emitter structure is effective for reducing the area occupied by the transistor and also effective for realizing high integration density and high performance of the bipolar type integrated circuit device.

However, according to said producing method shown in Fig. 1 to Fig. 3, the insulating film 19a which insulatingly isolates the emitter region forming window/emitter electrode window from the base electrode window is formed by the oxide material of the polycrystalline silicon layer 15 and oxidation of the surface of silicon epitaxial layer under said polycrystalline silicon layer 15. The insulating film formed by oxidation of such polycrystalline silicon layer is comparatively porous and has low insulation characteristic. In addition, a crystal defect is induced at the epitaxial layer surface (boundary to the oxide film) under the oxide film by the selective oxidation of the silicon epitaxial layer surface with the silicon nitride film pattern used as the mask. Therefore, it is difficult to sufficiently improve the electrical characteristic and reliability of a bipolar type semiconductor device formed by such a producing method.

It is an object of the present invention to provide a method of producing a bipolar semiconductor device which has eliminated the disadvantages of said conventional producing method and ensures excellent electrical characteristics and reliability.

It is another object of the present invention to provide a method of producing a bipolar semiconductor device wherein the emitter region can be formed by the self-alignment within the base region of a bipolar transistor.

It is a further object of the present invention to provide a method of producing the so-called walled emitter type bipolar transistor including a process for producing the base region and emitter region successfully preventing short-circuit between the emitter and collector of a bipolar transistor.

For this purpose, the present invention proposes a method of producing bipolar walled-emitter transistors with improved insulation between the emitter and base electrodes, comprising the steps of:

oxidizing directly an exposed surface defined by field insulating layer (104) of an epitaxial layer (103), formed on a substrate having a first conductivity, to form an insulating silicon dioxide layer (106),

forming a polycrystalline semiconductor layer (107) on said insulating layer (106),

introducing a second conductivity type impurity into said epitaxial layer (103) using a mask layer (108a, 108b) formed on said polycrystalline semiconductor layer (107), so as to form a first base region (109),

eliminating said mask layer (108a, 108b) and the polycrystalline semiconductor layer (107) thereunder,

selectively exposing the epitaxial layer surface, using the field insulating layers (104) and the remaining polycrystalline semiconductor layer (107a) or its oxide film (110) as the mask,

introducing a second conductivity type impurity into the epitaxial layer through said exposed surface, so as to form base regions (112a, 112b) in contact to said base region (109),

introducing selectively by using a further mask layer (113) a first conductivity type impurity into a region, where said second conductivity type impurity has been introduced, through said exposed surface so as to form a walled emitter region (114) in self alignment with the base region (112a),

forming emitter and base contact electrodes (115, 116) above said walled emitter region (114) and said base region (112b), resp.

A method for carrying out the invention is described in detail below with reference to drawings which illustrate several specific embodiments, in which:

Fig. 1 to Fig. 3 are sectional views indicating the conventional producing processes for a bipolar transistor.

Fig. 4 to Fig. 13 are sectional views indicating the first embodiment of a method of producing a bipolar transistor for the present invention.

Fig. 14 is the plan view indicating the structure of a bipolar transistor in relation to the present invention.

Fig. 15 to Fig. 19 are sectional views indicating the second embodiment of a method of producing a bipolar transistor in relation to the present invention.

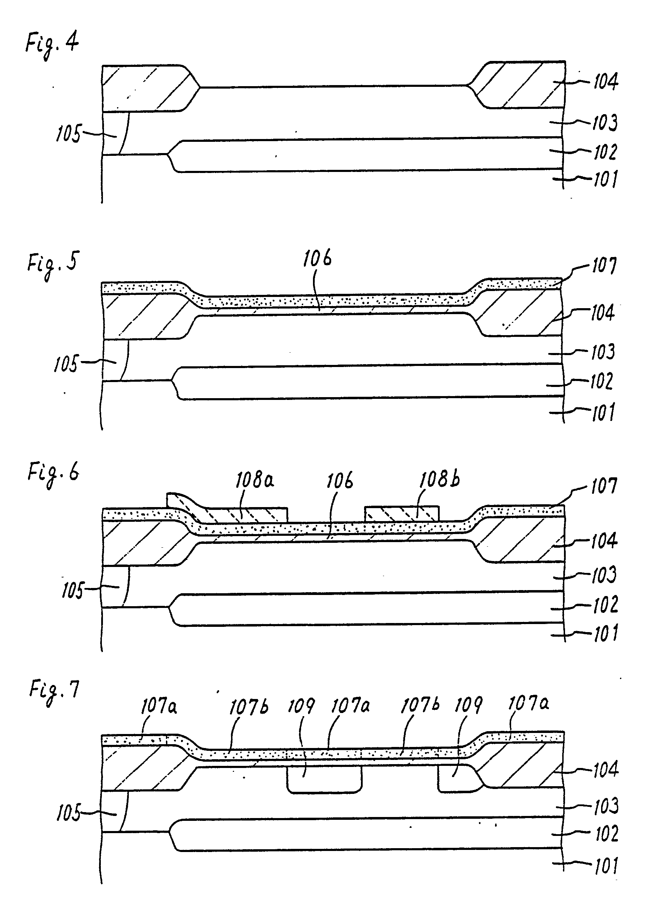

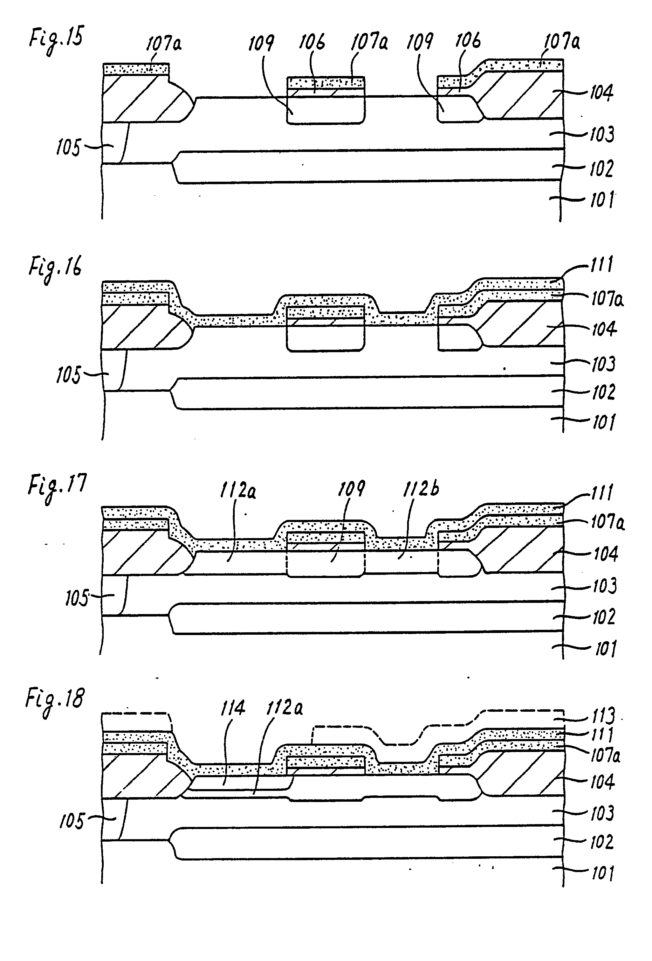

Fig. 4 to Fig. 13 show processes of the first embodiment of a method of producing a bipolar transistor in relation to the present invention. Such drawings are sectional views along the line A—A' in the plan view shown in Fig. 14.

In regard to Fig. 4:

(1) The $n^+$ type buried layer 102 is formed on the surface of the P type silicon substrate 101 by selectively introducing the donor impurity, for example, the antimony (Sb) or arsenic (As).

(2) The n type silicon epitaxial layer 103 is formed on the P type silicon substrate 101 containing said $n^+$ type buried layer 102.

(3) The surface of said n type epitaxial layer 103 is oxidized by the selective oxidation method, for example, using the silicon nitride film (not shown) as the mask and thereby the field insulating layer 104 consisting of the silicon dioxide ($SiO_2$) is formed.

These processes can be executed by existing well known producing process. In the structure shown in Fig. 4, the field insulating layer 104 defines the region wherein the base region is to be formed. In addition, on the epitaxial layer 103 under said field insulating layer 104, the $P^+$ type isolation region 105 which extends to the silicon substrate 101 from the lower surface of said field insulating layer 104 is deposited as required.

In regard to Fig. 5:

(4) The exposed surface of the epitaxial layer 103 defined by said field insulating layer 104 is then oxidized and the silicon dioxide layer 106 is formed in the thickness of 1000 to 3000 Å. Such oxidation processing can be realized by the existing well known thermal oxidation method.

(5) The nondoped polycrystalline silicon layer 107 is formed in the thickness of 1000 Å covering the surface of said silicon dioxide layer 106 and the field insulating layer 104. Such polycrystalline silicon layer 107 is formed, for example, by the chemical vapor deposition method using monosilane ($SiH_4$).

In regard to Fig. 6:

(6) The photoresist layer which specifies the emitter region forming window/emitter electrode window and the base electrode window forming region is formed on said polycrystalline silicon layer 107. The photoresist layer 108a specifies the emitter region forming window/emitter electrode window, while the photoresist layer 108b the base electrode window.

In regard to Fig. 7:

(7) The acceptor impurity, for example, the boron (B) is implanted by the ion implantation method using said photoresist layers 108a and 108b and the field insulating layer 104 as the mask. Such ion implantation is carried out in such a condition, for example, that the acceleration voltage is 60 KeV—100 KeV and the amount of dose or doping level is $10^{15}$ to $10^{16}$ atoms/cm$^2$.

(8) Such photoresist layer 108 is removed.

(9) For example, the P type base region 109 is formed by annealing under the nitrogen ($N_2$) ambient of 900°C is order to activate said boron ion. Said base region is formed, for example, with the depth of 300 to 4000 Å and surface sheet resistance of 400 cbms/square.

Simultaneously with deposition of such base region 109, a conductivity is given to the region 108a not covered with the photoresist 108 on said polycrystalline silicon layer 107.

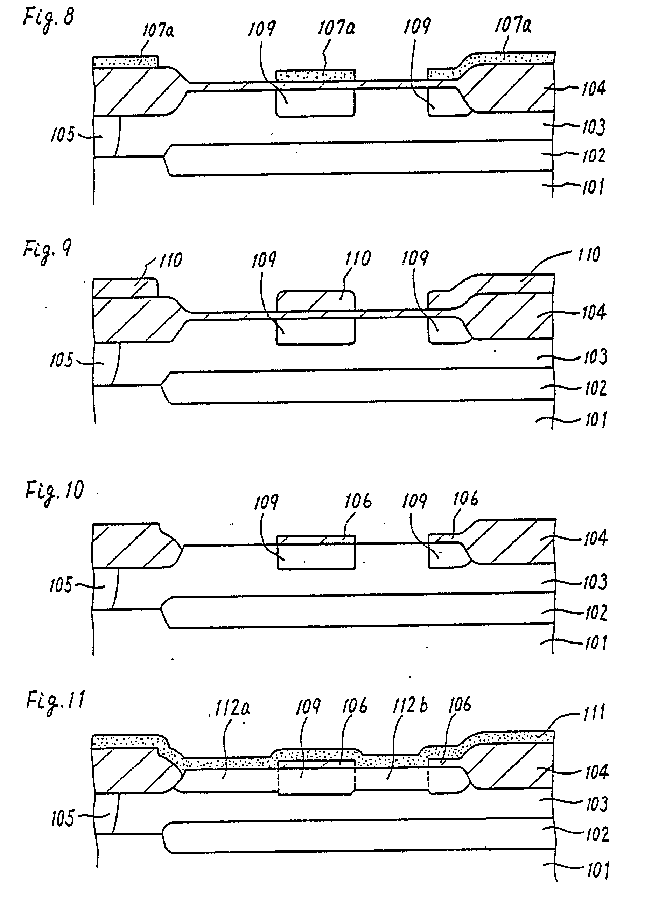

In regard to Fig. 8:

(10) The region to which impurity (boron) is not introduced on said polycrystalline silicon layer 107, namely the region 107b covered by said photoresist layer 108 is removed by the etching method. As the etching solution for such nondoped polycrystalline silicon layer, the aqueous solution of potassium hydroxide (KOH) in concentration of 10 to 30% (weight-%) is used. A ratio of etching rate to the nondoped polycrystalline silicon and the P type silicon for such aqueous solution of potassium hydroxide is 10:1 and the amount of etching of the P type polycrystalline layer 107a in said etching process is very little.

In regard to Fig. 9:

(11) Said polycrystalline layer 107a is oxidized and converted to the silicon dioxide layer 110. The thickness of said silicon dioxide layer 110 is about 2000 Å.

In regard to Fig. 10:

(12) Said silicon dioxide layer 110 is removed by the etching method. At this time, the silicon dioxide layer 106 not covered with said silicon dioxide layer 110 is removed by the etching and the silicon epitaxial layer 103 under said silicon dioxide layer 106 is selectively exposed. For removal of the silicon dioxide layers 110, 106, the wet etching using as etching solution fluoric acid (HF) or the dry etching using methane trifluoride ($CHF_3$) can be used.

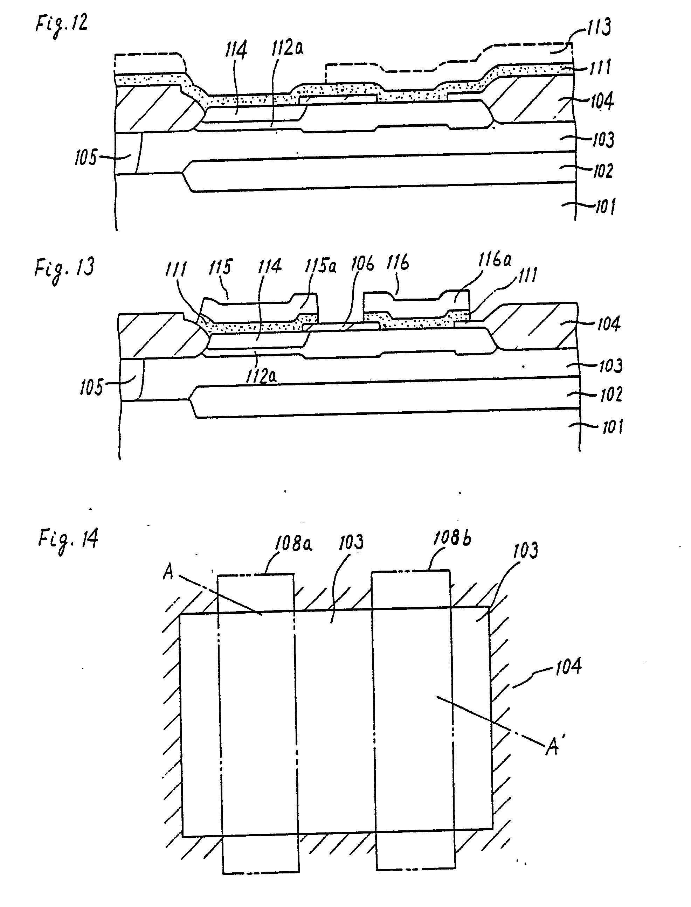

In regard to Fig. 11:

(13) The polycrystalline silicon layer 111 is formed in the thickness of 1000 Å, covering the exposed portion of said silicon epitaxial layer 103, the remaining portion 106a of the silicon dioxide layer 106 and the field insulating layer 104.

(14) The boron ion ($B^+$) is implanted through said polycrystalline silicon layer 111 using said silicon dioxide layer 106a and field insulating layer 104 as the mask. Such ion implantation is carried out under the condition that the accelerating voltage is 40 KeV and amount of dose is $10^{14}$ atoms/cm$^2$.

(15) The P type base region 112a and 112b are formed in contact to said P type base region 109 by annealing for example under the nitrogen ambient at 900°C in order to activate said boron ion. Such base regions 112a and 112b have a depth of 3000 Å and a surface sheet resistance of 800 ohms/square. The field insulating layer 104 is in contact with a part of said base regions 112a and 112b.

In regard to Fig. 12:

(16) The photoresist layer 113 is deposited covering said base region 112b.

(17) The donor impurity, for example, the arsenic (As) is ion-implanted into said base region 112a through the polycrystalline silicon layer 111 using said photo resist layer 113, field insulating layer 104 and silicon dioxide layer 106a etc. are used as the mask. Such ion implantation is carried out under the condition that the acceleration voltage is 70 KeV and amount of dose is $10^{16}$ atoms/cm$^2$.

(18) The photoresist layer 113 is removed.

(19) The $n^+$ type emitter region 114 is formed in the vicinity of the surface of said base region 112a by annealing, for example, under the nitrogen ambient at 900°C in order to drive-in said arsenic ion. Such emitter region 114 has a depth of 2000 Å and a surface impurity concentration of $10^{20}$ atoms/cm$^3$. A part of such emitter region 114 is placed in contact with the field insulating layer 104 forming a so-called walled emitter structure.

In regard to Fig. 13:

(20) The electrode metal material, for example the aluminium is deposited in a thickness of 1 μm on said polycrystalline silicon layer 111.

(21) Said aluminium layer and the polycrystalline silicon layer 111 thereunder are selectively etched by using the photoresist layer (not shown) as the mask and the emitter electrode 115 and base electrode 116 are formed. The upper layers 115a, 116a of each electrode are aluminium layers.

A bipolar transistor structure can be realized by above production processes, but if necessary, the multi-layered wiring structure is configured by the well known technique and thereafter the passivation film such as the phosphosilicate glass (PSG) etc. is deposited (not shown).

The collector electrode leadout portion, not shown, is formed by the following means. Namely, in case for forming the field insulating layer by executing the thermal oxidation to the surface of the epitaxial layer exposed within said base region forming window, the silicon nitride film is remained within the collector contact window for the use as the mask.

Prior to formation of the base region, the collector contact region is formed as usual by the ion implantation of the donor impurity under the condition that the base region forming window is covered with the resist film.

On occasion of P type impurity ion implantation in order to form the base region (processes shown in Fig. 7 and Fig. 11), the collector contact window is covered with the photoresist film.

The donor impurity to be introduced for the formation of the emitter region is introduced simultaneously into the collector contact window. Said polycrystalline silicon layer is also formed and deposited within the collector contact window.

In the above embodiment, the $N^+$ type emitter region is formed by the ion implantation method but said emitter region can be formed by the solid to solid diffusion from the phosphosilicate glass (PSG) film.

In addition, it is also possible, in this embodiment, to provide the silicon nitride layer ($Si_3N_4$) in a thickness of 500 to 700 Å between the silicon dioxide layer 106 and polycrystalline silicon layer 107. Such structure is capable of more improving the etching accuracy of the silicon dioxide layer 107.

Fig. 15 to Fig. 19 show the second embodiment of a method of producing a bipolar transistor of the present invention.

In the case of this embodiment, the processes from formation of the field insulating layer to the surface n type epitaxial layer to the selective formation of the base region and removal of the nondoped polycrystalline silicon layer, namely the processes shown in Fig. 4 to Fig. 8 in said first embodiment, are the same. Therefore, explanations and drawings of such processes are omitted here.

For explanation of this embodiment, the numbering given to each portion described for this first embodiment is also given in the same way to this embodiment.

In regard to Fig. 15:

(1) The silicon dioxide layer 106 is selectively removed by etching using the remaining P type polycrystalline silicon layer 107a as the mask.

For removal of silicon dioxide layer 106, the reactive ion etching method using the metane trifluoride ($CHF_3$) as etchant is employed.

The silicon epitaxial layer 103 is selectively exposed by such etching process.

In regard to Fig. 16:

(2) The polycrystalline silicon layer 111 is formed in the thickness of 1000 Å covering the exposed portion of said silicon epitaxial layer 103 and the polycrystalline silicon layer 107a.

Said polycrystalline silicon layer 111 can be formed, as explained above, by the chemical vapor deposition method using monosilane ($SiH_4$).

In regard to Fig. 17:

(3) The boron ion ($B^+$) is implanted through said polycrystalline silicon layer 111 using said silicon dioxide layer 106a and field insulating layer 104 as mask. Such ion implantation is carried out under the condition that the acceleration voltage is 40 KeV and amount of dose is $10^{14}$ atoms/cm².

(4) The P type base regions 112a and 112b are formed in contact with said P type base region 109 by annealing under the nitrogen ambient at, for example, 900°C in order to activate said boron ion. Such base regions 112a and 112b have a depth of 3000 Å and a surface sheet resistance of 800 ohms/square. A part of such base regions 112a, 112b is placed in contact with the field insulating layer 104.

In regard to Fig. 18:

(5) The photoresist layer 113 is deposited covering said base region 112b.

(6) the donor impurity, for example, the arsenic (As) is ion-implanted into the base region 112a through the polycrystalline silicon layer 111 with said photoresist layer 113, field insulating layer 104 and silicon dioxide layer 106a used as the mask. Such ion implantation is carried out under the condition that the acceleration voltage is 70 KeV and amount of dose is $10^{16}$ atoms/cm².

(7) The photoresist layer 113 is removed.

(8) The $n^+$ type emitter region 114 is formed in the vicinity of the surface of said base region 112a by annealing under the nitrogen ambient at, for example, 900°C in order to drive-in said arsenic ion. Such emitter region 114 has a depth of 2000 Å and a surface impurity concentration of $10^{20}$ atoms/cm³. A part of such emitter region 114 is placed in contact with the field insulating layer 104.

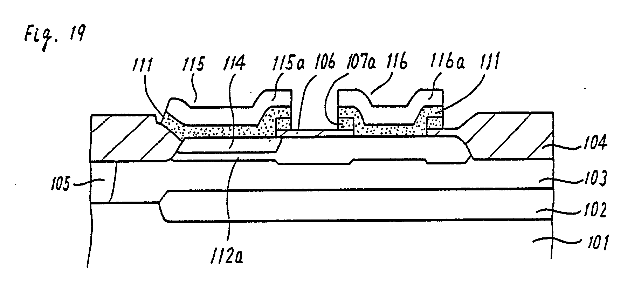

In regard to Fig. 19:

(9) the electrode metal material, for example, the aluminium is coated on said polycrystalline silicon layer 111 in a thickness of about 1 μm.

(10) the aluminium layer, polycrystalline silicon layers 111 and 107a provided thereto are removed by the selective etching with the photoresist layer (not shown) used as the mask and the emitter electrode 115 and base electrode 116 are formed. The upper portions 115a, 116a of each electrode are aluminium layers.

By above producing processes, a bipolar transistor structure can be realized. If necessary, the multi-layered wiring structure is formed by the well known technique and thereafter the passivation film such as phosphosilicate glass is deposited (not shown).

Also in the case of this second embodiment, the collection electrode leadout portion (not shown) can be formed with the same means as that described for said first embodiment.

According to above method of producing a bipolar transistor of the present invention, the insulating film which protects the exposed portion of the emitter-base junction and isolates electrically between the emitter electrode and base electrode is structured by the silicon dioxide layer 106 formed by directly oxidizing the surface of silicon epitaxial layer. Such dioxide layer 106 is very dense as compared with the silicon dioxide layer formed by oxidizing the polycrystalline silicon as in the case of the prior art. Moreover, the mask such as the silicon nitride film etc. is not used for forming such silicon dioxide layer 106. In addition, according to the present invention, the base region 112a and emitter region 114 are formed through the ordinary aperture formed on the silicon dioxide layer formed at the surface of said silicon epitaxial layer. Therefore, said emitter region 114 is self-aligned to the base region 112a in its location, resulting in the so-called walled emitter structure.

According to such present invention, the insulating film which electrically isolates the emitter electrode from the base electrode has a high insulation characteristic and does not give any thermal or mechanical stress or crystal defect on the semiconductor layer just under said insulating film. Therefore, the present invention provides a bipolar semiconductor device which does not result in poor insulation between the emitter and base electrodes. In addition, the present invention is capable of forming an emitter region which is self-aligned to the base region, namely realizes the so-called walled emitter structure. Resultingly, it does not require to provide a margin of alignment for the base region around the emitter region forming window, thus, reducing the area of said base region.

Reduction in the base region brings about a large effect on reduction in size of the pertinent bipolar transistor and is also effective for high integration density of a bipolar integrated circuit including said bipolar transistor.

Moreover, the reduced base region contributes much to reduction of parasitic capacitance between the base and collector and is also effective for improvement of electrical characteristic of the pertinent transistor in combination with reduction of the parasitic capacitance between emitter and base.

Namely, according to the present invention, a bipolar transistor having high reliability and high integration density can be produced with a high production yield.

## Claims

1. A method of producing bipolar walled-emitter transistors with improved insulation between the emitter and base electrodes, comprising the steps of:

oxidizing directly an exposed surface defined by field insulating layer (104) of an epitaxial layer (103), formed on a substrate having a first conductivity, to form an insulating silicon dioxide layer (106),

forming a polycrystalline semiconductor layer (107) on said insulating layer (106),

introducing a second conductivity type impurity into said epitaxial layer (103) using a mask layer (108a, 108b) formed on said polycrystalline semiconductor layer (107), so as to form a first base region (109),

eliminating said mask layer (108a, 108b) and the polycrystalline semiconductor layer (107) thereunder,

selectively exposing the epitaxial layer surface, using the field insulating layers (104) and the remaining polycrystalline semiconductor layer (107a) or its oxide film (110) as the mask,

introducing a second conductivity type impurity into the epitaxial layer through said exposed surface, so as to form base regions (112a, 112b) in contact to said base region (109),

introducing selectively by using a further mask layer (113) a first conductivity type impurity into a region, where said second conductivity type impurity has been introduced, through said exposed surface so as to form a walled emitter region (114) in self alignment with the base region (112a),

forming emitter and base contact electrodes (115, 116) above said walled emitter region (114) and said base region (112b), resp.

2. A method of producing semiconductor devices as claimed in claim 1, where said semiconductor substrate is composed of silicon.

3. A method of producing semiconductor devices claimed in claim 1, where said polycrystalline semiconductor layer is composed of polycrystalline silicon.

## Revendications

1. Procédé de fabrication de transistors bipolaires à émetteur muré à isolation améliorée entre les électrodes d'émetteur et de base, comprenant les étapes suivantes:

oxyder directement une surface exposée définie par une couche d'isolement de champ (104) d'une couche épitaxiale (103), formée sur un substrat ayant un premier type de conductivité, pour former une couche isolante de dioxyde de silicium (106),

former une couche semiconductrice polycristalline (107) sur la couche isolante (106),

introduire une impureté du second type de conductivité dans la couche épitaxiale (103) en utilisant une couche de masquage (108a, 108b) formée sur la couche semiconductrice polycristalline (107) de façon à former une première région de base (109),

éliminer la couche de masquage (108a, 108b) et la couche semiconductrice polycristalline (107) située en-dessous,

exposer sélectivement la surface de la couche épitaxiale, en utilisant les couches d'isolement de champ (104) et la couche semiconductrice polycristalline restante (107a) ou sa couche d'oxyde (110) comme masque,

introduire une impureté du second type de conductivité dans la couche épitaxiale par la surface exposée de façon à former des régions de base (112a, 112b) en contact avec ladite région de base (109),

introduire sélectivement, en utilisant une autre couche de masquage (113), une impureté du premier type de conductivité dans une région où l'impureté du second type de conductivité a été introduite, à travers la surface exposée de façon à former une région d'émetteur muré (114) en auto-alignement avec la région de base (112a),

former des électrodes de contact d'émetteur et de base (115, 116) au dessus de la région à émetteur muré (114) et de la région de base (112b), respectivement.

2. Procédé de fabrication de dispositif semiconducteur selon la revendication 1, dans lequel le substrat semiconducteur est constitué de silicium.

3. Procédé de fabrication de dispositif semiconducteur selon la revendication 1, dans lequel la couche semiconductrice polycristalline est constituée de silicium polycristallin.

**Patentansprüche**

1. Verfahren zur Herstellung bipolarer Transistoren mit umwandeten Emittern mit einer verbesserten Isolation zwischen Emitter- und Basiselektroden, mit den folgenden Schritten:

direkte Oxidierung einer exponierten Oberfläche, die durch eine Feldisolierschicht (104) einer epitaktischen Schicht (103) begrenzt ist, welche auf einem Substrat gebildet ist, das eine erste Leitfähigkeitsart hat, um eine isolierende Siliziumdioxidschicht (106) zu bilden,

Bildung einer polykristallinen Halbleiterschicht (107) auf der isolierenden Schicht (106),

Einführung von Verunreinigungen eines zweiten Leitfähigkeitstyps in die genannte epitaktische Schicht (103), unter Verwendung einer Maskenschicht (108a, 108b), die auf der genannten polykristallinen Halbleiterschicht (107) gebildet ist, um so einen ersten Basisbereich (109) zu bilden,

Eliminierung der genannten Maskenschicht (108a, 108b) und der polykristallinen Halbleiterschicht (107) darunter,

selektive Exponierung der epitaktischen Oberflächenschicht unter Verwendung der Feldisolierschichten (104) und der verbleibenden polykristallinen Halbleiterschicht (107a) oder ihres Oxidfilms (110) als die Maske,

Einführung von Verunreinigungen eines zweiten Leitfähigkeitstyps in die epitaktische Schicht durch die exponierte Oberfläche, um so Basisbereiche (112a, 112b) zu bilden, die mit dem Basisbereich (109) in Kontakt stehen,

selektive Einführung von Verunreinigungen eines ersten Leitfähigkeitstyps, unter Verwendung einer weiteren Maskenschicht (113), in einen Bereich, wo die Verunreinigung von dem genannten zweiten Leitfähigkeitstyp eingeführt worden ist, durch die genannte exponierte Oberfläche, um so einen umwandeten Emitterbereich (114) in Selbstausrichtung mit dem Basisbereich (114a) zu bilden,

Bildung von Emitter- und Basiskontaktelektroden (115, 116) oberhalb des umwandeten Emitterbereichs (114) bzw. des Basisbereichs (112b).

2. Verfahren zur Herstellung von Halbleitervorrichtungen nach Anspruch 1, bei welchem das genannte Halbleitersubstrat aus Silizium zusammengesetzt ist.

3. Verfahren zur Herstellung von Halbleitervorrichtungen nach Anspruch 1, bei welchem die genannte polykristalline Halbleiterschicht aus polykristallinem Silizium zusammengesetzt ist.

*Fig. 1*

16    17    15

14

12

13

11

*Fig. 2*

16    18a    18b    17    19

14

12

13

11

*Fig. 3*

20    15a    21    19a    15b    22

19

14

12

13

11

Fig. 4

105 — 104
103
102
101

Fig. 5

106
107
105 —
104
103
102
101

Fig. 6

108a  106  108b
107
105 —
104
103
102
101

Fig. 7

107a  107b  109  107a  107b  109  107a
105 —
104
103
102
101

Fig. 8

Fig. 9

Fig. 10

Fig. 11

**Fig. 12**

**Fig. 13**

**Fig. 14**

4

0 070 499

**Fig.15**

107a — 109 — 106 — 107a — 109 — 106 — 107a
104
103
102
105
101

**Fig.16**

111
107a
104
103
102
105
101

**Fig.17**

112a — 109 — 112b — 111
107a
104
103
105
102
101

**Fig.18**

114 — 112a — 113
111
107a
104
103
105
102
101

5

Fig. 19